Europäisches Patentamt

European Patent Office

Office européen des brevets

(19)

(11) Publication number: **0 092 926**
A2

# (12) EUROPEAN PATENT APPLICATION

(21) Application number: 83301993.8

(22) Date of filing: 08.04.83

(51) Int. Cl.³: **H 01 L 27/14**
H 01 L 29/78, H 04 N 3/15

(30) Priority: 22.04.82 GB 8211732

(43) Date of publication of application:
02.11.83 Bulletin 83/44

(84) Designated Contracting States:
DE FR IT NL

(71) Applicant: The Secretary of State for Defence in Her
Britannic Majesty's Government of The United Kingdom
of Great Britain and
Northern Ireland Whitehall
London SW1A 2HB(GB)

(72) Inventor: Ballingall, Ronald Alexander
"Highfield" The Groton
Ashton-under-Hill Worcestershire(GB)

(72) Inventor: Frier, Alistair Arthur Grant
29 Whitworth Road
Southampton Hamsphire(GB)

(74) Representative: Edwards, John Brian et al,
Procurement Executive Ministry of Defence Patents 1 A
(4), Room 2014 Empress State Building Lillie Road
London SW6 1TR(GB)

(54) Background subtraction in a charge transfer device; method and apparatus thereof.

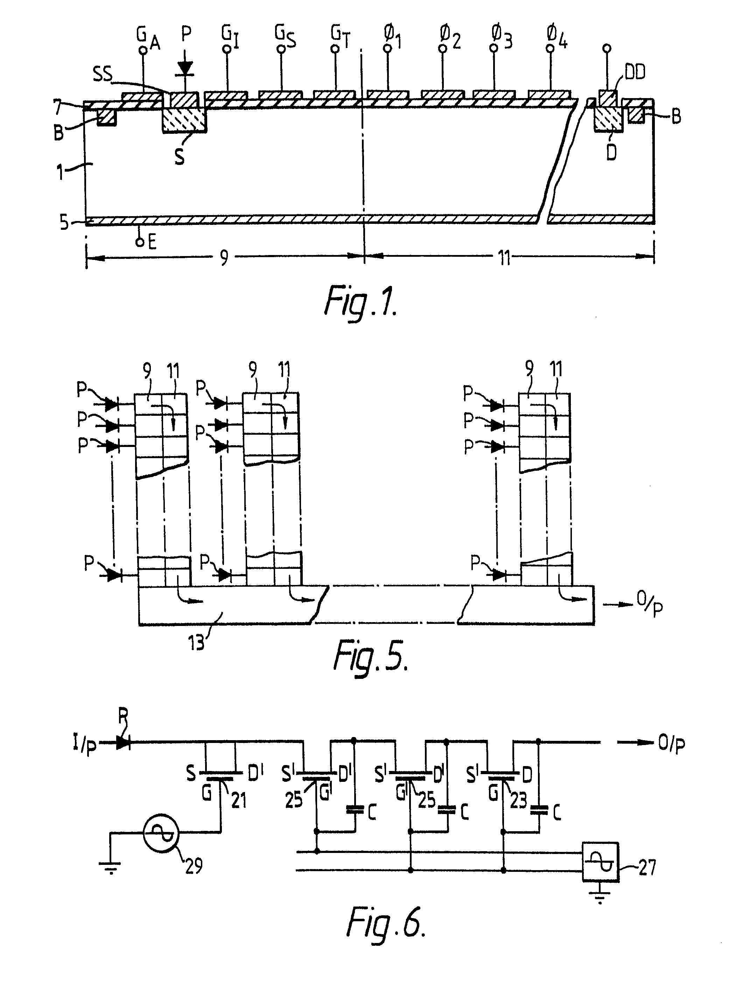

(57) In a charge transfer device (Figure 1) an auxiliary charge store and gate (G_A) is provided adjacent to the devices input (9) - ie adjacent to the device source (S), or to the device first store (beneath G_S), or to both. In order to provide background subtraction, charge is transferred back and forth, under auxiliary gate control, between the device input (9) and the auxiliary store (beneath G_A) many times during each period of charge integration and a fixed increment of charge is removed for each such transfer. The total charge subtracted each integration period is dependent on the number of transfers; this latter is determined by the frequency of a control signal applied to the auxiliary gate (G_A). This frequency may be set manually, or may be servoed by output circuitry in order to set an automatic adaptive threshold.

*Fig.1.*

- 1 -

Background Subtraction in a Charge Transfer Device; Method and Apparatus therefor

TECHNICAL FIELD

This invention concerns background subtraction in a charge transfer device (CTD); particularly in an infra-red charge coupled device (IR-CCD) - a charge coupled device (CCD) incorporated in the structure of an infra-red image sensor - as also in other CCDs and bucket brigade devices (BBDs).

A typical infra-red image sensor comprises an array of detector elements - for example infra-red sensitive photodiodes - elements arranged in rows and columns. Each column of elements is read-out by means of a multiple input CCD register - an input register, and each input register is read-out by means of another multiple input CCD register - an output register. Each input register fulfils two functions. Firstly, it enables the signal from the elements to be read-out in a sequence. Secondly, it enables time integration of each signal, as representative sample charge is accumulated in the input storage wells (stores) of the CCD during each sampling interval - this resulting in noise smoothing and thus improvement of signal over noise - and ideally this sampling interval is as long as is possible. In practice, however, the sampling interval - the integration period - is limited by CCD well storage capacity and by the maximum signal current handled. Typically, in 8 to 14 μm band sensitive CMT on silicon sensors the integration period is very short, limited to an interval of the order of tens of microseconds. All the elements in the array must be read-out in this time,
if the hottest partsof the imaged scene are to be resolved. Thus
even in an array of modest size - eg 32 x 32 elements - the output
register read-out rate is rapid. For a 32 x 32 element array and a
sampling period of 50 μs, the read-out rate at output would need to
be 50 ns per element (pixel) - ie a rate of 20 MHz. Such rates
are very fast for CCDs and this imposes stringent requirements on
the design of CCD used.

The photodiode signal, as also the representative charge accumulated
during sampling of the signal, may be considered as comprised of
two components: one component, a background component of relatively
large magnitude, dependent on scene ambient temperature; the other
component, a component of much smaller magnitude, dependent on scene
temperature difference above ambient. It is the latter small
component only that conveys the contrast information of the scene.
Background subtraction is used to remove, or at least to
substantially reduce, the background component.

PRIOR ART
One method of background subtraction, a so-called "charge-skimming"
method, has been described by Fraser & Alexander et al in a paper
entitled "An Extrinsic Silicon Charge Coupled Device for Detecting
Infra-red Radiation", IEDM, Washington DC, Tech. Digest 442-5 (1974).
According to this method, charge is accumulated in a first input-
well, and as this well saturates and overflows, excess charge is
accumulated in a second well immediately adjacent to the first.
This excess charge is then clocked along the transfer channel of the
CCD and read-out. According to a variant of this method, and during
a somewhat extended sampling period, the first input well is emptied
periodically.

The method described however, only compounds problems of device nonuniformity. Though common control voltages can be applied to each of the several device inputs' control gates, the effective well potentials that are developed are very sensitive to material parameters. It is difficult, if not impossible to control these parameters to sufficient tolerance to ensure that the input well potentials are identical. Thus the charge subtracted from one input will differ from that subtracted at another, and the output signal produced will thus contain fixed pattern noise

By way of background, reference is also made to a paper given by Brugler & Jaspers entitled "Charge Pumping in MOS Devices", IEEE Trans. Electron Devices, ED-16 No 3 pages 297-302 (March 1969). In this paper the authors have identified and analysed charge pumping, an effect found to limit the sensitivity of charge storage mode operation of phototransitors or diodes. See also IEEE J Solid State Circuits, Vol SC-2 pages 65-73 (Sept 1967).

DISCLOSURE OF THE INVENTION

In accordance with the invention there is provided a method of background subtraction in a charge transfer device wherein signal charge is accumulated in a first store during a period of integration, and thereafter transferred to device output, a portion of the signal charge being removed periodically during the period of integration, this method being characterised by the repeated interchange of charge between the device source region and/or the first store, and an auxiliary store, an increment of charge being removed as device substrate current for each full excursion of the interchanged charge, many increments of charge being removed during each period of integration.

The total quantum of charge subtracted each integration period is thus determined by the size of each charge increment, and by the number of increments of charge removed each period. It is possible to define the number of increments each period precisely, and although the increment size will depend on device parameters - eg gate electrode dimensions, inter-surface state density - these parameters can be maintained uniform within adequate tolerance over an extensive area of the device. It is thus possible to remove charge with reasonable precision, and thus reduce the contribution to fixed pattern noise considerably, whilst retaining the benefits of charge subtraction. Furthermore, as charge is subtracted in a quasi-continuous manner during integration, charge accumulates more slowly, and a longer period can be allowed for integration. This allows more effective smoothing of noise, particularly of the lower frequency noise components. Also if the method is applied in an infra-red image sensor of the kind described above, the output register can be operated at a relatively slow rate, and the choice of CCD design is thus less restrictive.

In further accordance with the invention there is provided apparatus for performing the method herein disclosed, this apparatus comprising the combination of:

a charge transfer device including a source, a drain, a plurality of stores between the source and the drain, and transfer gates for controlling the transfer of charge from store to store;

a control circuit for controlling periodic release of charge accumulated in the first store nearest the source, from the first to a second store, each release following a period of integration; and,

a phase clock connected to the transfer gates of the device, for applying phase signals to those gates to transfer charge from store to store and to the drain;

the apparatus being characterised by:

an auxiliary store and gate adjacent the source and/or the first store; and,

a control generator connected to the auxiliary gate, to apply a time variant voltage gate signal, to effect a repeated interchange of charge between the source, the first store, or both, and the auxiliary store, to interchange charge many times each period of integration.

The apparatus may be an infra-red image sensor system, one in which the charge transfer device has a multiplicity of inputs, the source and/or the first store of each input being associated with a corresponding auxiliary gate and store; the system including a multiplicity of infra-red detecting elements arranged in an array, each one controlling a corresponding one of the device sources, and, a common signal generator connected to each one of the auxiliary gates.

It is convenient to include as signal generator, one providing a periodic voltage signal - either continuous (eg sinusoid, square wave, triangular wave) or pulsed. It is preferable that the generator is capable of adjustment, to enable adjustment of gate signal frequency, fundamental frequency or pulse repetition frequency. Adjustment may be manual, allowing the user to set a common subtraction threshold to optimise response for different scene background levels, or to emphasise high-level features of interest. This adjustment could be automated. The generator could be connected to respond to signal output circuits and used to apply an adaptive threshold.

In yet further accordance with this invention there is provided a charge coupled device for use as the charge transfer device in the apparatus disclosed above, this device comprising:

    a semiconductor substrate including doped regions providing device source and drain;

    a layer of insulating material extending over the surface of the substrate;

    means delineating a charge transfer channel of the substrate extending between source and drain;

    a plurality of transfer electrodes arranged above the insulating layer and along the device, each extending across the channel, a first one of these electrodes being immediately adjacent to the source;

the device being characterised by:

an auxiliary gate electrode, also immediately adjacent to the source.

Preferably, the gate electrode and the first transfer electrode are shaped so that together they surround the source.

The transfer channel may be a surface channel (as in a SCCD) or a buried channel (as in a BCCD).

BRIEF INTRODUCTION OF THE DRAWINGS

In the drawings accompanying this application:

Figure 1 is an illustrative cross-section of a charge coupled device, a device modified to facilitate charge subtraction;

Figure 2 is a plan view of the input structure of an alternative charge coupled device, a device also modified to facilitate charge subtraction;

Figures 3 and 4 show respectively in cross-section and folded cross-section the input structure of the device shown in figure 2 above, sections taken along lines X-X and Y-Y of that figure;

Figure 5 is an illustrative drawing of an infra-red image sensor showing the organisation of sensor elements and CCD; and,

Figure 6 is a circuit diagram of a MOSFET bucket brigade device arranged to facilitate charge subtraction.

DESCRIPTION OF PREFERRED EMBODIMENTS

The invention will now be described, by way of example only, with reference to embodiments shown in the accompanying drawings.

An infra-red imaging charge coupled device, which for the most part is of conventional design, is shown in simplified form in figure 1. It comprises a substrate 1 of semiconductor material, a region S of which is doped by implantation or by diffusion to provide the the source S of the device. At the remote end of this device, another region is likewise doped to provide the device drain D. Metal contacts for the source - contact SS - and for the drain - contact DD - are provided. The base of the substrate 1 is coated with a metallic layer 5, to provide the ground contact E of the device. The upper surface of the substrate 1 is covered by a layer 7 of insulating material, which provides isolation between a set of transfer electrodes and the semiconductor material of the substrate 1. The set of transfer electrodes comprises: a first electrode immediately adjacent the source S (the input gate $G_I$); and this is followed by a storage control gate $G_S$; a transfer control gate $G_T$; and, a plurality of phase gates, arranged in groups of four, gates $\phi_1$, $\phi_2$, $\phi_3$, $\phi_4$ - of which one group only is shown. Each of the phase gates $\phi_1$, $\phi_2$, $\phi_3$ and $\phi_4$ is connected to a different phase-line of a 4-phase control clock (not shown). The set of transfer electrodes span the space between the device source S and the drain D, and extend across a transfer channel delineated in the substrate 1 by means of an isolation boundary - a boundary of dopant enriched material or of thick oxide B.

A sensing element, an infra-red photosensitive detector - photo-diode P - is connected at the input contact SS of the device. Charge is injected into the source S, and is accumulated, in the first store of the device, a region beneath the storage gate $G_S$. From here it is transferred to stores beneath the phase gates $\phi_1$, $\phi_2$, $\phi_3$ and $\phi_4$ under the control of the phase clock and a control circuit (not shown) connected to the transfer gate $G_T$.

In addition to the conventional structure thus far described, the device includes an auxiliary gate $G_A$. This is located on the opposite side of the source to the first electrode, input gate $G_I$. It could instead be located to one side of the source S, or even alongside the first electrode $G_I$, and preferably it is patterned to surround the remaining perimeter of the source contact SS.

The diode P may be one of many, arranged in one- or two-dimensional array, and the device may be accordingly of complex structure. A two-dimensional array implementation is shown schematically in figure 5. In this structure the device has a multiplicity of loading inputs 9. The structure of each loading input 9 corresponds to the input part of the device shown in figure 1, the region of the device extending from the auxiliary gate $G_A$ and source S, to the transfer gate $G_T$ inclusive. The signal charge of each input is transferred into a corresponding storage location 9 of an input register 11 and from parallel input registers 11 into an output register 13 where it is transferred to the device drain D to develop a serial output signal.

During operation, charge subtraction is effected by applying a time variant voltage control signal, for example a cyclic signal which varies between a Hi level and a Lo level each cycle, to each auxiliary gate $G_A$.

The principle of operation is as follows: as the gate voltage on an auxiliary gate $G_A$ goes Hi, charge is attracted from the source S and from the first store under the transfer electrode $G_S$, into the auxiliary store, the region beneath the auxiliary gate $G_A$, ie into an inversion layer. Subsequently as this gate voltage goes Lo during the remaining part of the time variant signal cycle, charge is returned to the source S and first store. However, some of the charge, an increment $\Delta Q$ of charge, recombines and appears as substrate current - ie current flowing between the input diode P and the substrate E. This subtracted increment contains two components, one corresponding to recombination via surface states, the other corresponding to recombination in the bulk.

Each time charge is interchanged between the source S, the first store and the auxiliary store, the increment $\Delta Q$ subtracted is given by:

$$\Delta Q = (\alpha Q_p + q N_{ST})A_G \quad, \quad \text{where:}$$

$\Delta Q$ = net trapped charge per gate cycle (C);

$\alpha$ = fraction of free carriers under auxiliary gate that recombines in the bulk;

$Q_p$ = free charge density in the inversion layer $(G/cm^2)$;

$q$ = electronic charge (C);

$N_{ST}$ = total fast inter-surface-state density contributing to the charge pumping effect $(cm^{-2})$; and,

$A_G$ = area of the auxiliary gate.

The substrate current $I_B$ thus produced, as increments are removed each cycle of the auxiliary gate signal, is thus given by:

$$I_B = \Delta Q \cdot\cdot f_G$$
$$= A_G \cdot f_G \, (-\alpha \, C_o \, (V_G - V_T) + q \, N_{ST}) \quad, \quad \text{where:}$$

$f_G$ = the frequency, fundamental frequency or pulse repetition frequency of the auxiliary gate voltage signal;

$C_o$ = oxide capacitance per unit area $(F/cm^2)$

$V_G$ = auxiliary gate voltage (V); and

$V_T$ = a threshold voltage (V).

Thus the total charge $Q_T$ removed during an integration period $\tau$ is simply:

$$Q_T = I_B \cdot \tau \, \propto \, f_G \cdot \tau$$

Thus by pulsing or modulating the voltage on the auxiliary gate $G_A$, some of the photocurrent charge that would be stored under the storage gate $G_S$, flows under the auxiliary gate and is pumped away. Hence a fixed amount of charge can be bled off and dumped. In this way the background charge can be subtracted to leave the wanted signal charge. Because now the charge flowing into the first store accumulates more slowly, the integration time can be increased and hence the sensitivity of the array improved. Because the amount of pumped current is proportional to gate signal frequency, the amount of background subtraction can be controlled accurately, to much the same precision as the frequency. If the scene background changes, the background subtraction can be changed by adjusting the auxiliary gate control frequency. For example if the ambient temperature changes from say 300 to 320 $^{o}$K the frequency of the gate signal can be increased so that more background charge is subtracted.

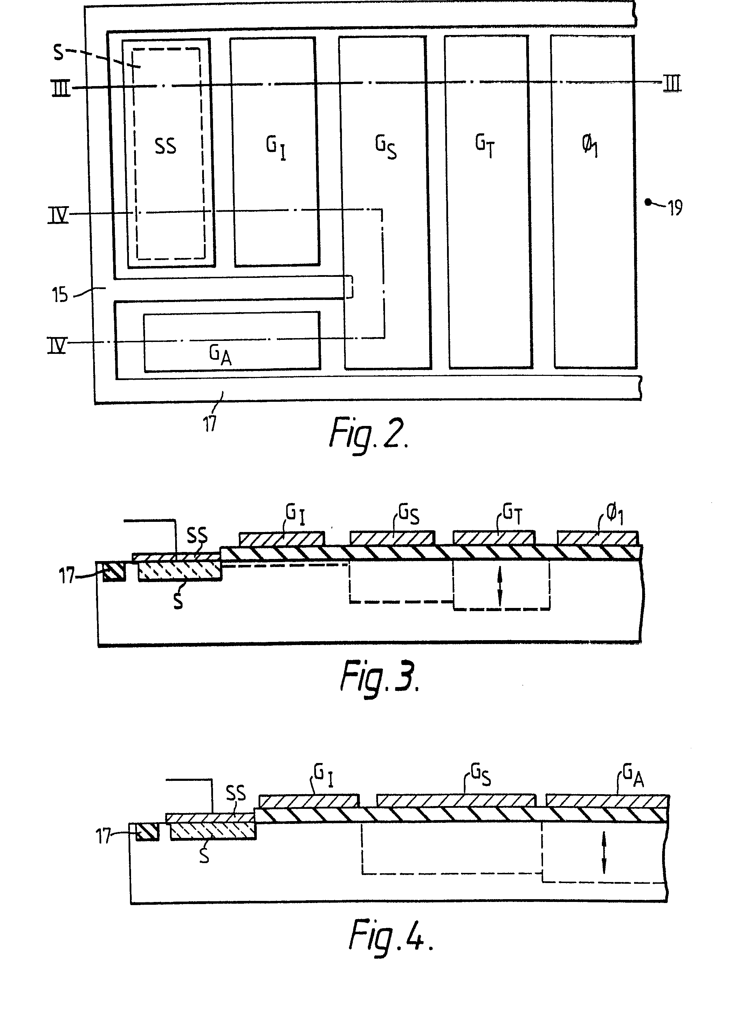

An alternative CCD structure is shown in figures 2, 3 and 4. In this structure the auxiliary store, which is located beneath the auxiliary gate $G_A$, is isolated from the source S. As shown, the auxiliary gate $G_A$ is located adjacent the input electrode S and the input gate $G_I$, both of which are foreshortened. The source S and auxiliary store are isolated by means of an insulating barrier 15, an extension of the excess doped boundary 17 used to delineate the transfer channel 19. The far end of the auxiliary gate $G_A$ is immediately adjacent part of the storage gate $G_S$. Where the time variant control signal is applied to the auxiliary gate $G_A$, charge is interchanged between the first store, ie the region beneath the storage gate $G_S$, and the auxiliary store, ie the region beneath the auxiliary gate $G_A$.

As typical example, the substrate 1 may be of p-type silicon single crystal, <100> cut, material of resistivity between 10 and 20 $\Omega$cm; the source diffusion 3, and the drain diffusion, of depth approx 1.8 µm and sheet resistivity approx 150 $\Omega$/sq; the insulating

material silicon oxide of thickness 1200 $\overset{o}{A}$. Typical electrode dimensions are as follows:

auxiliary store gate $G_A$:    80 µm long x 25 µm wide;

input control gate $G_I$:    20 µm long x 200 µm wide; and,

storage gate $G_S$

transfer gate $G_T$    }  :    20 µm long x 230 µm wide.

phase gates $\phi_1$ to $\phi_4$

A bucket brigade device (BBD) is shown in the circuit diagram of figure 6, a fully integrated MOS structure. As in a BBD of conventional structure - see for example Philips Tech Review 31, pages 97-110 (1970) - it comprises a series of capacitative charge stores C, lying between the source S of an input MOSFET 21 and the drain D of a terminal, ie output, MOSFET 23. Transfer of sample charge from store to store, and to output O/P, is controlled by MOSFET transistor switches 25, which are each connected between the store capacitors C. The drain contact D' of each transistor switch 25 is connected to the source contact S' of the next switch 25, and each store capacitor C bridges the drain contact D' and control gate G' of a corresponding transistor switch 25. Alternate transistor gates G' are connected to a different one of two phase lines P1 or P2, which in turn are connected to a 2-phase control clock 27.

The input MOSFET 21, however, is modified and controlled to provide charge subtraction. The source contact S and drain contact D' of this MOSFET are connected in common and are associated with a photo-diode P which provides the signal current. This current is sampled, and charge is accumulated in the first store, store C of the nearest MOSFET 25. As this charge accumulates, however, the voltage applied to the control gate G of the input transistor 21 is varied under the control of an auxiliary generator 29. Charge from the source S and drain D' of the input transistor 21, and from the source S' and drain D' of the adjacent transistor 25 and the first store C, is thus transferred to and from auxiliary store - ie a region beneath the control gate G of the input transistor 21 - as the auxiliary gate voltage varies. This results in charge pumping action and the removal of many increments of charge, in manner similar to that already described.

## CLAIMS

1. A method of background subtraction in a charge transfer device (Figure 1) wherein signal charge is accumulated in a first store (under $G_S$) during a period of integration, and thereafter transferred to device output (D), a portion of the signal charge being removed periodically during the period of integration, this method being characterised by the repeated interchange of charge between the device source region (S) and/or the first store (under $G_S$), and an auxiliary store (under $G_A$), an increment of charge being removed as device substrate current for each full excursion of the interchanged charge, many increments of charge being removed during each period of integration.

2. Apparatus for performing the method as claimed in claim 1; this apparatus comprising the combination of:

a charge transfer device (Figure 1) including a source (S), a drain (D), a plurality of stores (under $G_S$, $\phi_1-\phi_4$) between the source (S) and the drain (D), and transfer gates ($G_I$, $G_S$, $G_T$, $\phi_1-\phi_4$) for controlling the transfer of charge from store to store;

a control circuit for controlling periodic release of charge accumulated in the first store nearest the source (S), from the first (under $G_S$) to a second store (under $\phi_1-\phi_4$), each release following a period of integration; and,

a phase clock connected to the transfer gates ($\phi_1-\phi_4$) of the device, for applying phase signals to those gates to transfer charge from store to store and to the drain (D);

the apparatus being characterised by:

an auxiliary store (under $G_A$) and gate ($G_A$) adjacent the source (S) and/or the first store (under $G_S$); and,

a control generator connected to the auxiliary gate ($G_A$), to apply a time variant voltage gate signal, to effect a repeated interchange of charge between the source (S), the first store (under $G_S$), or both, and the auxiliary store (under $G_A$), to interchange charge many times each period of integration.

3. An infra-red image sensor system (Figure 5), being apparatus as claimed in claim 2, wherein the charge transfer device has a multiplicity of inputs (9), and the source (S) and/or the first store (beneath $G_S$) of each input (9) being associated with a corresponding auxiliary gate ($G_A$) and store; the system including a multiplicity of infra-red detecting elements (P) arranged in an array, each one controlling a corresponding one of the device sources (S); each auxiliary gate ($G_A$) being connected to a signal generator.

4. A system as claimed in claim 3 wherein each auxiliary gate ($G_A$) is connected to a common signal generator.

5. Apparatus as claimed in any one of the preceding claims 2 to 4, wherein each signal generator provides a periodic voltage signal.

6. Apparatus as claimed in claim 5, including a signal output circuit and control means responsive to this circuit, for setting the frequency of each signal generator for applying an adaptive threshold.

7. A charge coupled device (Figure 1) for use as the charge transfer device in the apparatus as claimed in claim 2, this device comprising:

a semiconductor substrate (1) including doped regions providing device source (S) and drain (D);

a layer (7) of insulating material extending over the surface of the substrate (1);

means (B) delineating a charge transfer channel of the substrate (1) extending between source (S) and drain (D);

a plurality of transfer electrodes ($G_I$, $G_S$, $G_T$, $\phi_1$-$\phi_4$) arranged above the insulating layer (7) and along the device, each extending across the channel, a first one ($G_I$) of these electrodes being immediately adjacent to the source (S);

the device being characterised by:

an auxiliary gate electrode ($G_A$), also immediately adjacent to the source (S).

8. A device as claimed in claim 7 wherein the auxiliary gate $(G_A)$ and the first transfer electrode $(G_I)$ together surround the source (S).

Fig.1.

Fig.5.

Fig.6.

0092926

Fig. 2.

Fig. 3.

Fig. 4.